Europäisches Patentamt

European Patent Office

Office européen des brevets

(11) Publication number: **0 272 688**
**A2**

## (12) EUROPEAN PATENT APPLICATION

(21) Application number: 87119053.4

(22) Date of filing: 22.12.87

(51) Int. Cl.⁴: **G11C 19/28**

(30) Priority: 22.12.86 JP 303921/86

(43) Date of publication of application:
29.06.88 Bulletin 88/26

(84) Designated Contracting States:
DE NL

(71) Applicant: FUJI PHOTO FILM CO., LTD.
210 Nakanuma Minami Ashigara-shi
Kanagawa 250-01(JP)

(72) Inventor: Miida, Takashi
c/o Fuji Photo Film Co., Ltd. No.798,
Miyanodai,
Kaisei-machi, Ashigarakami-gun,
Kanagawa(JP)
Inventor: Murayama, Jin
c/o Fuji Photo Film Co.,Ltd. No.798,
Miyanodai,
Kaisei-machi, Ashigarakami-gun,
Kanagawa(JP)
Inventor: Kondo, Ryuji
c/o Fuji Photo Film Co.,Ltd. No.798,
Miyanodai,
Kaisei-machi, Ashigarakami-gun,
Kanagawa(JP)

(74) Representative: Patentanwälte Grünecker,
Kinkeldey, Stockmair & Partner
Maximilianstrasse 58
D-8000 München 22(DE)

(54) **An output amplifier for a charge transfer device.**

(57) A capacitive level shift circuit is used to shift the level of the output of a charge transfer device from a high level down to a low level typically used in processing circuits to which the charge transfer device output is provided.

*FIG. 3*

## AN OUTPUT AMPLIFIER FOR A CHARGE TRANSFER DEVICE

### Background of the Invention

This invention relates to an output amplifier for a charge transfer device, and particularly to an output amplifier suitable for a charge transfer device actuated with a high voltage power source.

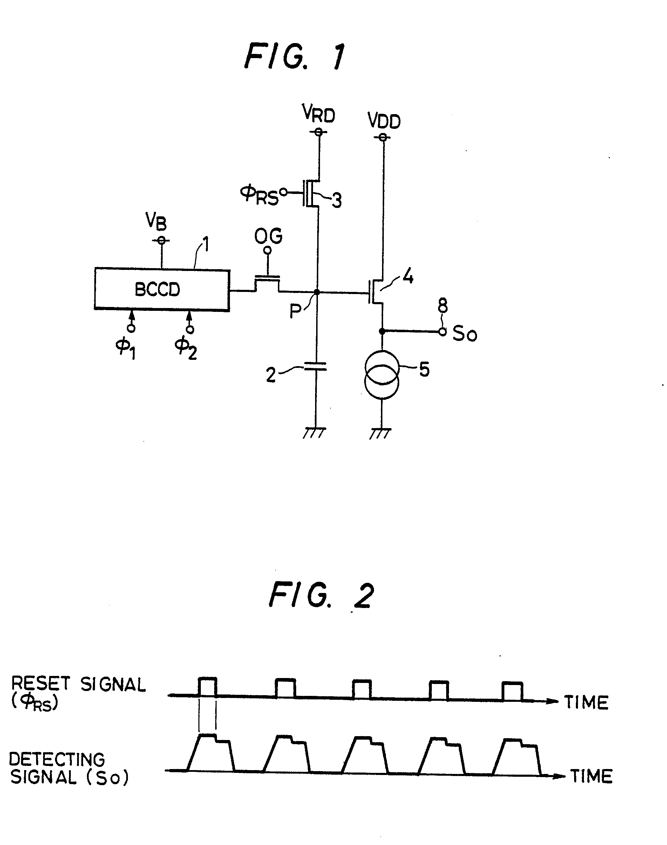

Fig. 1 shows an output amplifier of a conventional bombarding channel type charge coupled device (BCCD). Reference numeral 1 represents a transfer portion of the BCCD for transferring signal charges according to transfer clock signals $\phi_1$ and $\phi_2$. An output gate transistor having its gate coupled to an output gate (OG) signal is provided at an end of the transfer portion 1, and a capacitor 2 is connected through the output gate transistor to the end of the transfer portion 1. A floating diffusion P, i.e., a connection between one end of the output gate transistor and the capacitor 2, is connected both to a first voltage source $V_{RD}$ through a MOSFET transistor 3 for reset and to a gate of a MOSFET 4 constituting an impedance converting circuit.

The MOSFET 4 has a drain connected to a second voltage source $V_{DD}$ and a source connected through a constant current source 5 to ground. The source voltage of the MOSFET 4 is provided to the output terminal 8.

One example of the construction of an ordinary BCCD is as follows. A thin n-type layer is formed on the surface of a p-type silicon substrate, and a transfer electrode is formed on the thin n-type layer. A relatively high reverse bias voltage is applied to the thin n-type layer to expel free electrons (majority carriers) from dopants in the n-type layer and generate a depletion layer consisting of dopant ions, so that a transfer channel is formed in the bulk of the n-type layer away from the Si-SiO₂ interface. Accordingly, when proper clock pulses $\phi_1$ and $\phi_2$ are applied to the transfer electrode, the signal charge is transferred in the transfer channel. As a result, transfer efficiency and transfer speed can be improved.

Next, the operation of an output amplifier having the above construction will be described hereinafter with reference to Figs. 1 and 2. Signal charge transferred from the transfer portion 1 of the BCCD is transferred through the output gate transistor to the floating diffusion P. Immediately before the transfer of the signal charge to the floating diffusion P, a reset signal $\phi_{RS}$ is set to a high (H) level to render the transistor 3 conductive. Accordingly, the potential of the floating diffusion P is positively reset to a voltage of the voltage source $V_{RD}$ before the signal charge is read out. After the above step, the signal charge from the transfer portion 1 is provided through the output gate transistor and a potential drop corresponding to the amount of the signal charge occurs in the floating diffusion P, so that the signal charge is subjected to impedance conversion and is then outputted as a detecting signal $S_0$ to the output terminal 8.

However, in the output amplifier of the charge transfer device actuated with a high voltage source as described above, the transfer channel of the BCCD is kept in a high potential state and therefore signal charge cannot be effectively detected unless the potential of the floating diffusion P is reset to a higher potential than the potential of the transfer channel. Accordingly, the voltage of the voltage source $V_{DD}$ must be maintained extremely high, e.g., at least 10 V, and similarly the voltage of the other voltage source $V_{DD}$ must be kept high, so that it is difficult to combine the BCCD or the like with circuits actuated with a low voltage source.

Furthermore, for ordinary use, detecting signal $S_0$ is applied to and operated on by a logical circuit actuated with a relatively lower voltage, and therefore a large gap occurs between the level of the voltage $V_{CC}$ to be applied to the logic circuit and the level of the voltages $V_{RD}$ and $V_{DD}$ to be applied to the output amplifier of the BCCD, so that compatibility becomes a problem.

Accordingly, it is an object of this invention to provide an output amplifier for a charge transfer device operable with a low voltage source.

### Summary of the Invention

To attain the above and other objects, the output amplifier according to the present invention for detecting signal charge transferred from a transfer channel in a charge transfer device is characterized in that a level shift circuit with capacitive elements is provided at an end of the output of the charge transfer device.

### Brief Description of the Drawings

The invention will be more clearly understood from the following description in conjunction with the accompanying drawings, in which:

Fig. 1 shows a conventional output amplifier of a charge transfer device;

Fig. 2 shows a timing chart for explaining the operation of the circuit shown in Fig. 3;

Fig. 3 shows an embodiment of an output amplifier of a charge transfer device according to this invention; and

Fig. 4 shows a timing chart for explaining the operation of the circuit shown in Fig. 1.

Detailed Description of the Invention

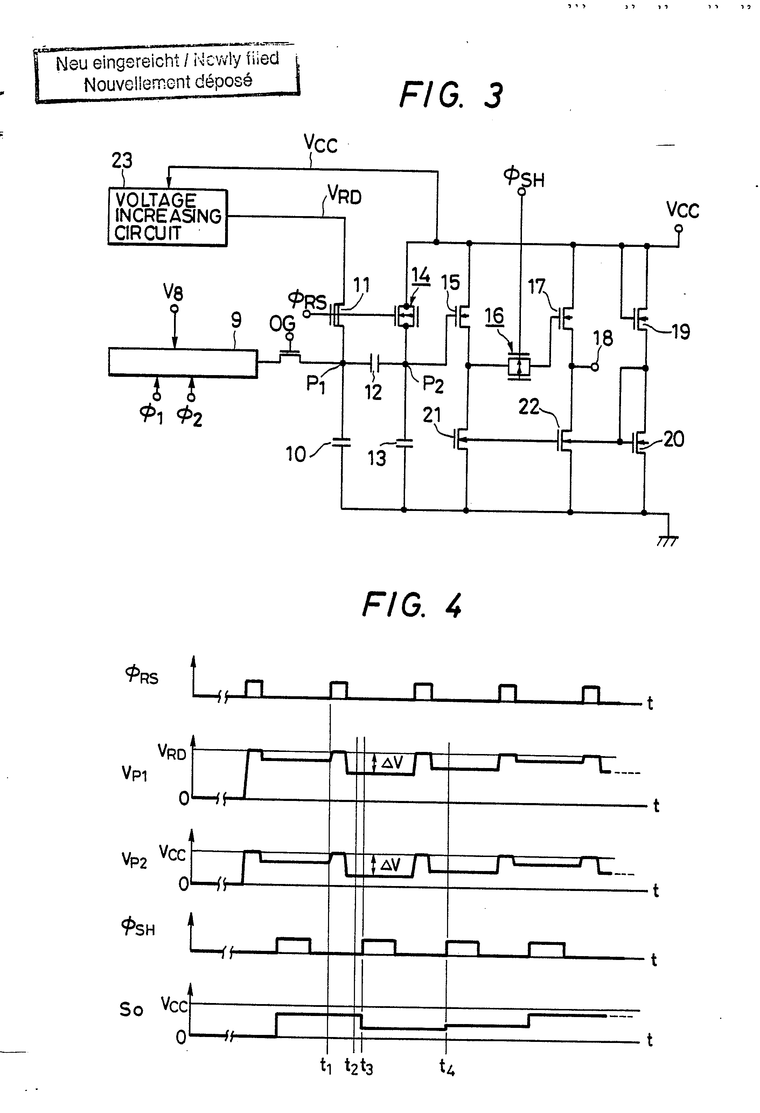

An embodiment of a charge transfer device output amplifier according to this invention will be described hereinafter with reference to Fig. 3.

In Fig. 3, reference numeral 9 represents a BCCD of the type shown in Fig. 1. An output gate transistor having its gate controlled by the output gate signal OG connects a floating diffusion $P_1$ to the BCCD. The floating diffusion $P_1$ is also connected through a first capacitive element 10 to ground, and is connected through a reset MOSFET 11 to a first power source line $V_{RD}$. Finally, the diffusion $P_1$ is connected to one end of a second capacitive element 12. The connection point $P_2$ at the output side of the capacitive element 12 is connected through a third capacitive element 13 to ground, connected through an analog switch 14 to a second power source line $V_{CC}$, and is further connected to the gate of the MOSFET 15 with source follower configuration. The source of the MOSFET 15 is connected through an analog switch 16 to the gate of the MOSFET 17 with source follower configuration, and the source of the MOSFET 17 is connected to an output terminal 18.

MOSFETs 19 and 20 are connected in series with each other between the power source $V_{CC}$ and ground to form a current source circuit for generating a desired current. The MOSFET 20 and a pair of MOSFETs 21 and 22 comprise a current mirror circuit for supplying the MOSFETs 15 and 17 with a desired current.

The analog switch 16 is supplied with a sample-and-hold signal $\phi_{SH}$, and the combination of the analog switch 16 and the MOSFETs 17 and 22 carries out a sample-and-hold operation. A reset signal $\phi_{RS}$ is applied simultaneously to the MOSFET 11 and to the analog switch 14, to reset the floating diffusion $P_1$ and the connection point $P_2$ to the voltages of the first and second power source lines $V_{DD}$ and $V_{CC}$, respectively.

Reference numeral 23 represents a voltage increasing circuit for increasing the voltage of the second power source line $V_{CC}$ by means of a charge pumping circuit or the like, and for generating the voltage of the first power source line $V_{RD}$. In this embodiment, the second power source line $V_{CC}$ is set to a voltage approximately in the range of 3 to 5 volts, which is required for operating an ordinary logic circuit, and the first power source line $V_{RD}$ is set to about 10 volts.

The operation of the output amplifier as described above will now be described with reference to a timing chart shown in Fig. 4. Before a signal charge is transferred from the transfer portion of the BCCD 9, a reset signal $\phi_{RS}$ is shifted to a high level, e.g., at a time $t_1$, to make the MOSFET 11 and the analog switch 14 conductive, so that the potential $M_{P1}$ of the floating diffusion $P_1$ is reset to the voltage $V_{RD}$ and the potential $V_{P2}$ of the connection point $P_2$ is reset to the voltage $V_{CC}$.

After completion of the above resetting operation, the signal charge is transferred from the transfer portion of the BCCD 9 through the output gate OG thereby to generate a drop-out voltage $\Delta V$ (at a time $t_2$) corresponding to the signal charge at both of the floating diffusion $P_1$ and the connection point $P_2$. That is, since the floating diffusion $P_1$ and the connection point $P_2$ are connected through the capacitive element $C_2$ to each other, the connection point $P_2$ suffers the same drop-out voltage $\Delta V$ as suffered by the floating diffusion $P_1$.

The output terminal 18 has the same voltage as is maintained at the connection point $P_2$ at the time ($t_3$) when a sample-and-hold signal $\phi_{SH}$ is shifted to a high level, and outputs therefrom a signal $S_0$ of a voltage corresponding to the signal charge.

As described above, a signal of high voltage level $V_{RD}$ is shifted to a signal of low voltage level $V_{CC}$ by the configuration of the capacitive elements 10, 12 and 13 in this invention, so that a high voltage source is not demanded for an output amplifier, unlike a conventional output amplifier. As a result, the output amplifier can use the same low voltage source as employed in a signal processing circuit to be connected to the output terminal 18. This simplifies compatability problems between the BCCD and signal processing circuit to improve the flexibility in design, and the BCCD can be easily and effectively used in a circuit operated with a low voltage source.

According to this invention as described above, the capacitive configuration is used to shift the signal generated at the output terminal of the charge transfer device to an actuating voltage level for a circuit which is operated with a low voltage source, so that a charge transfer device operated with a high voltage source and a circuit operated with a low voltage source can be easily matched and combined.

Claims

1. An output amplifier for detecting signal charge transferred from a transfer channel of a charge transfer device, said output amplifier comprising:

a first capacitor having first and second terminals;

first means for setting said first terminal to a first predetermined voltage level prior to a first time;

second means for setting said second terminal to a second predetermined voltage level different from said first predetermined level prior to said first time;

connecting means for connecting said signal charge to a first terminal at said first time to cause a change in the voltage level at said first terminal and a change in the voltage level at said second terminal which corresponds to said change at said first terminal; and

output means for providing an output in accordance with the voltage level at said second terminal.

2. An output amplifier as claimed in Claim 1, wherein said first predetermined level is higher than said second predetermined level.

3. An output amplifier as claimed in Claim 1, wherein said first means comprises a switching transistor coupled between said first terminal and a source of voltage of said first predetermined level and said second means comprises an analog switch coupled between said second terminal and a source of voltage of said second predetermined level.

4. An output amplifier as claimed in Claim 3, wherein switching transistor and switch are actuated by a common signal.

5. An output amplifier as claimed in Claim 3, wherein said source of voltage of said first predetermined level comprises a voltage increasing circuit having an input coupled to said source of voltage of said second predetermined level for increasing the voltage at its input to obtain a voltage of said first predetermined level.

6. An output amplifier as claimed in Claim 1, wherein said output means comprises first and second transistors each having a conduction path between first and second transistor terminals and a control terminal with the conduction of each said conduction path varying in accordance with the voltage level at the respective control terminal, the control terminal of said first transistor being coupled to said first terminal of said capacitor, the first terminals of each of said first and second transistors being coupled to a source of voltage of said second predetermined level, current supply means coupled to the second terminal of each of said first and second transistors for supplying each of said first and second transistors with a desired current, and further switch means for connecting said second terminal of said first transistor to the control terminal of said second transistor after said first time.

# FIG. 1

# FIG. 2

RESET SIGNAL
($\phi_{RS}$)  → TIME

DETECTING
SIGNAL (So)  → TIME

# FIG. 3

# FIG. 4